# FASCICULE DE BREVET EUROPEEN

(11) **EP 4 063 973 B1**
(45) Date de publication et mention de la délivrance du brevet: **26.03.2025**
(21) Numéro de dépôt: 21205508.1
(22) Date de dépôt: 29.10.2021
(51) Int. Cl.: G04C 3/04, G04C 3/14

(54) **PIÈCE D HORLOGERIE INCORPORANT UN ACTUATEUR COMPRENANT UN DISPOSITIF ÉLECTROMÉCANIQUE**
UHR MIT INTEGRIERTEM STELLGLIED, DAS EINE ELEKTROMECHANISCHE VORRICHTUNG UMFASST
TIMEPIECE INCLUDING AN ACTUATOR COMPRISING AN ELECTROMECHANICAL DEVICE

(30) Priorité: 23.03.2021 EP 21164369
(43) Date de publication de la demande: 28.09.2022
(73) Titulaire: The Swatch Group Research and Development Ltd, 2074 Marin (CH)
(72) Inventeur: IMBODEN, Matthias, 2072 St-Blaise (CH); MIGNOT, Jean-Pierre, 25300 Pontarlier (FR)
(74) Mandataire: ICB SA

(56) Documents cités:
- WO-A1-2018/177779
- CH-A2- 715 399

## Description

### Domaine technique de l'invention

La présente invention concerne une pièce d'horlogerie incorporant un actuateur formé par un dispositif électromécanique qui comprend un système électromagnétique formé par un aimant permanent et une bobine. Le dispositif électromécanique comprend un élément mécanique pouvant subir un mouvement entre une position de repos et une position de contact avec une partie prédéterminée de la pièce d'horlogerie lorsque le système électromagnétique est activé par un circuit électrique de commande.

L'actuateur selon l'invention peut notamment servir à effectuer des impulsions de freinage mécanique qui sont appliquées à un résonateur mécanique, en particulier au balancier d'un balancier-spiral formant un tel résonateur mécanique, pour réguler sa fréquence moyenne ou corriger une dérive temporelle détectée dans la marche de la pièce d'horlogerie.

### Arrière-plan technologique

Un actuateur du type donné ci-avant est par exemple décrit dans la demande de brevet WO 2018/177779 en lien avec la figure 4. L'actionneur comprend une lame flexible qui est actionnée par un système électromagnétique bobine-aimant. Un problème avec un tel actuateur vient du fait qu'en l'absence d'alimentation de la bobine, la lame flexible peut facilement subir des déplacements intempestifs depuis la position de repos prévue en cas de chocs ou même de relativement petites accélérations engendrées par des mouvements de l'avant-bras d'un porteur de la pièce d'horlogerie incorporant l'actuateur. Ces déplacements peuvent engendrer des impulsions de freinage parasites qui s'appliquent au balancier-spiral et qui perturbent alors son fonctionnement et en particulier la régulation prévue de sa fréquence moyenne. La lame flexible peut même osciller suite à un choc ou un mouvement brusque de l'utilisateur de la pièce d'horlogerie et engendrer une série d'impulsions de freinage parasites.

En effet, bien que la lame flexible est mécaniquement rappelée vers une position de repos en l'absence d'activation du système électromagnétique, comme ceci est prévu entre la génération sur commande des impulsions de freinage (l'activation du système électromagnétique étant prévue seulement lors de la génération des impulsions de freinage pour limiter la consommation électrique de l'actuateur), cette force ce rappel mécanique est faible à proximité de la position de repos. De manière connue, la force élastique augmente de manière linéaire avec l'éloignement de la lame flexible de sa position de repos. Ainsi, cette lame flexible vibre facilement et peut aisément présenter des mouvements intempestifs dont l'amplitude est suffisante pour que la lame flexible vienne toucher le balancier.

### Résumé de l'invention

Le but de la présente invention est de pallier le problème technique mis en lumière dans l'arrière-plan technologique en fournissant une pièce d'horlogerie incorporant un actuateur dont la position de repos d'un organe flexible, actionné par un système électromagnétique, est plus stable pour empêcher ou au moins diminuer, au cas où la pièce d'horlogerie est soumise à des accélérations lorsqu'elle est portée au poignet d'un utilisateur, le risque de mouvements intempestifs de cet organe flexible avec une amplitude telle que l'actuateur puisse engendrer une impulsion parasite sur une partie déterminée de la pièce d'horlogerie, notamment sur le balancier d'un résonateur mécanique.

Pour atteindre l'objectif susmentionné, l'invention concerne une pièce d'horlogerie incorporant un actionneur formé d'un dispositif électromécanique, comprenant un système électromagnétique et un élément mécanique qui est mobile en translation et associé au système électromagnétique, et d'un circuit électrique de commande. Le système électromagnétique est formé d'un aimant permanent et d'une bobine dont l'un parmi les deux est porté par un organe flexible du dispositif électromécanique et l'autre par un support de cet organe flexible. L'élément mécanique fait partie de l'organe flexible et l'actionneur est agencé de manière à permettre, en réponse à un signal électrique d'activation généré par le circuit électrique de commande et fourni à la bobine pour engendrer une force électromagnétique entre cette bobine et l'aimant permanent, un mouvement de l'élément mécanique depuis une position de repos, dans laquelle il est prévu que l'élément mécanique demeure en l'absence d'une activation du système électromagnétique, jusqu'à une position de contact avec une partie déterminée de la pièce d'horlogerie. Ensuite, l'organe flexible est formé au moins partiellement par un élément élastique qui est agencé de manière à engendrer une force mécanique de rappel de l'élément mécanique en direction de la position de repos sur au moins une majeure partie de la distance que peut parcourir l'élément mécanique, lorsque le circuit électrique de commande génère ledit signal électrique d'activation, entre la position de repos et la position de contact, cette position de contact terminant ladite au moins une majeure partie de ladite distance. De plus, l'actionneur comprend en outre un élément magnétique qui est agencé de manière à pouvoir interagir avec l'aimant permanent pour engendrer entre eux une force magnétique qui s'exerce sur l'élément mécanique lorsque ce dernier est dans la position de repos, cette force magnétique ayant un sens opposé à celui de la force électromagnétique sur au moins une partie initiale de ladite distance depuis la position de repos et une intensité qui diminue, sur ladite au moins une partie initiale, lorsque l'élément mécanique s'éloigne de la position de repos, cette intensité étant inférieure à l'intensité que présente la force électromagnétique pour n'importe quelle position de l'élément mécanique dans ladite au moins une partie initiale.

Grâce à l'agencement d'un élément magnétique additionnel dans l'actuateur selon l'invention, la position de repos de l'organe flexible est rendue plus stable, de sorte que l'élément mécanique mobile en translation demeure en général dans cette position de repos en l'absence d'un signal électrique d'activation fourni à la bobine. Ainsi, le risque de contact entre l'élément mécanique et la partie déterminée de la pièce d'horlogerie, en l'absence d'un signal électrique d'activation, est fortement diminuée. En particulier, ladite partie déterminée est un balancier formant un oscillateur mécanique d'un mécanisme mécanique que comprend la pièce d'horlogerie.

### Brève description des figures

L'invention sera décrite ci-après de manière détaillée à l'aide des dessins annexés, donnés à titre d'exemples nullement limitatifs, dans lesquels :
- la Figure 1 est une vue en perspective, fond ouvert et masse oscillante enlevée, d'une première variante d'un premier mode de réalisation d'une montre selon l'invention ;
- la Figure 2 est un grandissement partiel de la Figure 1 ;
- les Figures 3A et 3B sont des représentations linéaires du dispositif électromécanique de l'actionneur incorporé dans la montre de la Figure 1, respectivement dans une position de repos de l'organe flexible de ce dispositif électromécanique et dans une position de contact avec le balancier de la montre ;
- les Figures 4A et 4B sont des représentations linéaires, similaires à celles des Figures 3A et 3B, d'une deuxième variante du dispositif électromécanique selon le premier mode de réalisation ;
- les Figures 5A et 5B montrent des courbes de force en fonction d'un déplacement de l'élément mécanique, selon un axe Z, pour diverses forces intervenant dans le dispositif électromécanique de la deuxième variante représentées aux Figures 4A et 4B ;
- La Figure 6 donne une courbe montrant la dynamique de l'élément mécanique au cours d'une impulsion de freinage appliquée au balancier de la montre ;
- La Figure 7 représente des lignes du champ magnétique d'un aimant permanent en forme de disque plein formant le système électromagnétique du premier mode de réalisation ;
- les Figures 8A et 8B sont des représentations linéaires, similaires à celles des Figures 3A et 3B, d'un deuxième mode de réalisation du dispositif électromécanique d'une montre selon l'invention ;
- la Figure 8C est un agrandissement partiel de la Figure 8A ;
- les Figures 9A, 9B et 9C concernent un troisième mode de réalisation d'une montre selon l'invention et sont des représentations similaires à celles des Figures 8A à 8C ;
- les Figures 10A et 10B sont des représentations partielles du dispositif électromécanique du troisième mode de réalisation respectivement pour deux positions différentes de l'élément mécanique formé par ce dispositif électromécanique ;
- les Figures 11A et 11B montrent des courbes de force en fonction d'un déplacement, selon un axe Z, d'un élément magnétique de stabilisation de la position de repos de l'organe flexible, formant le dispositif électromécanique du troisième mode de réalisation, pour diverses forces intervenant dans le dispositif électromécanique du troisième mode de réalisation ;
- les Figures 12A, 12B et 12C concernent un quatrième mode de réalisation d'une montre selon l'invention et sont des représentations similaires à celles des Figures 9A à 9C ;
- les Figures 13A et 13B montrent des courbes de force en fonction d'un déplacement, selon un axe Z, d'un élément magnétique de stabilisation de la position de repos de l'organe flexible, formant le dispositif électromécanique du quatrième mode de réalisation, pour diverses forces intervenant dans le dispositif électromécanique du troisième mode de réalisation.

### Description détaillée de l'invention

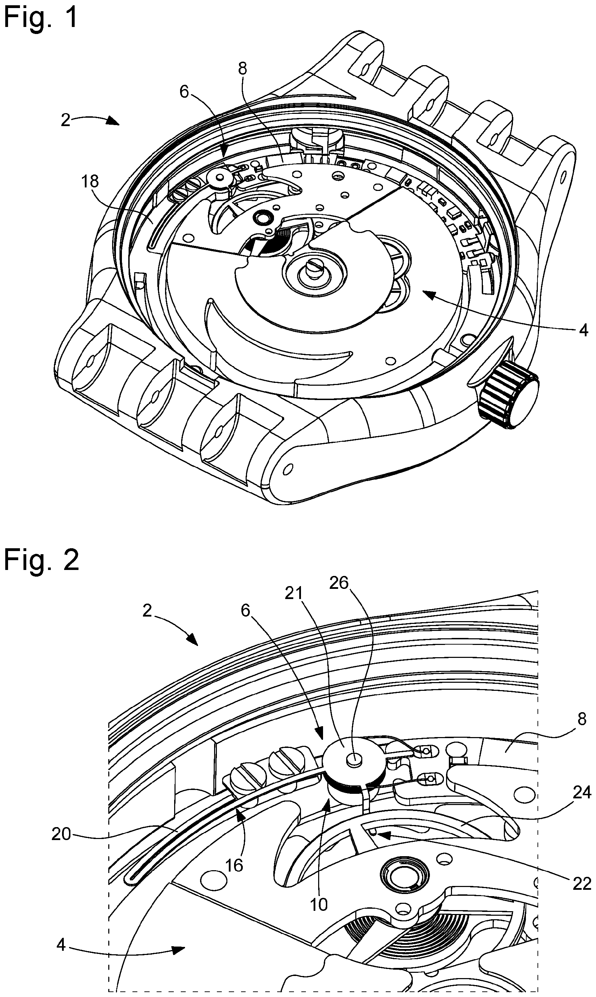

En référence aux Figures 1 à 6, on décrira ci-après un premier mode de réalisation d'une pièce d'horlogerie selon l'invention.

Une première variante est représentée aux Figures 1 à 3B. La montre 2, représentées aux Figures 1 et 2 sans le fond du boîtier et sans la masse oscillante du mouvement mécanique 4, incorpore un actionneur formé d'un dispositif électromécanique 6 et d'un circuit électrique de commande 8. Le dispositif électromécanique comprend un système électromagnétique 10 et un élément mécanique 22 qui est mobile en translation, selon un axe Z, et associé au système électromagnétique. Le système électromagnétique 10 est formé d'un aimant permanent 12 et d'une bobine 14, cette dernière étant portée par un organe flexible 16, formant le dispositif électromécanique, alors que l'aimant permanent est porté par un support 18 de cet organe flexible. On notera qu'à la Figure 2, la partie du support à laquelle est fixée, au moyen de deux vis, l'organe flexible 16 a été enlevée pour rendre apparent l'aimant permanent.

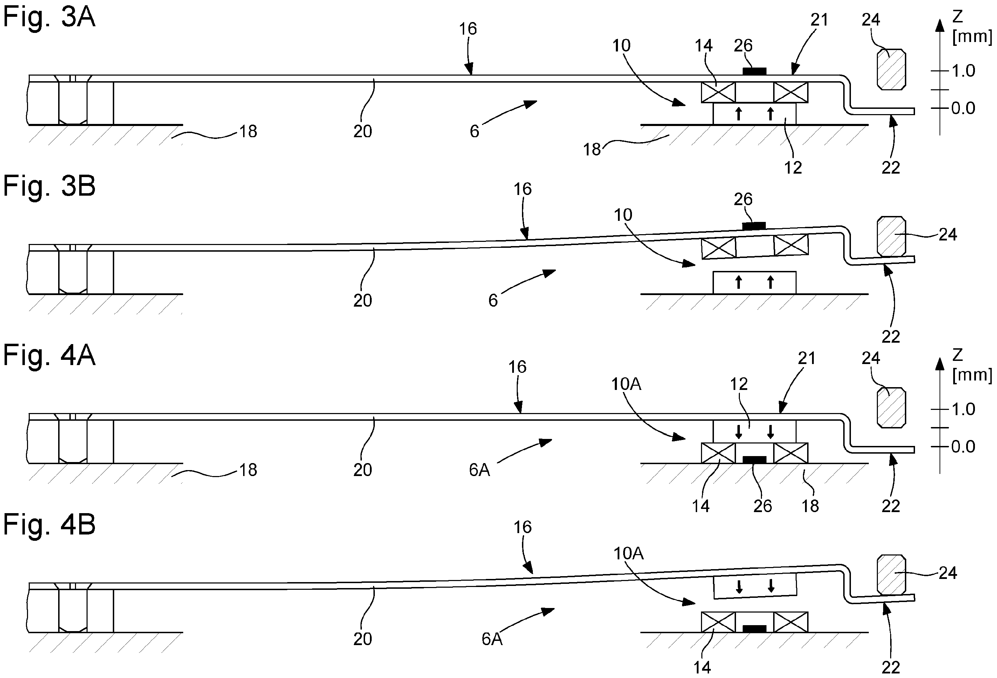

L'organe flexible 16 est formé au moins partiellement par un élément élastique 20. Cet organe flexible comprend l'élément mécanique 22 qui peut faire partie de cet élément élastique ou être fixé à celui-ci. L'élément élastique 20 est agencé de manière à engendrer une force mécanique de rappel de l'élément mécanique 22 en direction d'une position de repos de l'organe flexible sur au moins une majeure partie de la distance que peut parcourir cet élément mécanique selon l'axe Z, lorsque le circuit électrique de commande génère un signal électrique d'activation, entre sa position de repos, définie par la position Z = 0.0 à la Figure 3A, et la position de contact avec la serge 24 d'un balancier du résonateur mécanique du mouvement mécanique 4, cette position de contact terminant ladite au moins une majeure partie de ladite distance. La position de contact correspond sensiblement à une distance Z = 0.5 mm pour l'élément mécanique 22. Dans la variante représentée, l'élément élastique est formé avantageusement par une lame élastique 20 qui est repliée sur elle-même de manière à augmenter sa longueur pour un encombrement donné du dispositif électromécanique 6.

L'organe flexible est formé par une base fixée au support 18, la lame élastique 20, un disque plat 21 à l'extrémité libre de la lame élastique et l'élément mécanique 22 qui est venu de matière avec le disque plat et qui est relié à ce dernier via une partie coudée. On notera que l'élément mécanique 22 forme une sorte de patin permettant d'appliquer à la serge 24 des impulsions de freinage mécanique par un contact entre ce patin et le dessous de cette serge. Pour ce faire, il faut que l'élément mécanique 22 puisse exercer une certaine force sur une surface inférieure de la serge 24, ce que permet l'actionneur décrit ici. L'élément mécanique 22 fait donc partie de l'organe flexible 16 bien qu'il ne soit pas lui-même nécessairement flexible, mais il est relié à l'extrémité libre de l'élément élastique 20, directement ou par une autre partie de l'organe flexible, de manière qu'il puisse subir un déplacement lorsque l'élément élastique est soumis à une force de déformation engendrée par le système électromagnétique 10, comme ceci est montré à la Figure 3B.

L'actionneur est agencé de manière à permettre, en réponse à un signal électrique d'activation généré par le circuit électrique de commande 8 généralement sous forme d'impulsions électriques et fourni à la bobine 14 pour engendrer une force électromagnétique de répulsion entre cette bobine et l'aimant permanent 12, un mouvement de l'élément mécanique 22 depuis la position de repos (Z = 0.0), dans laquelle il est prévu que l'élément mécanique demeure en l'absence d'une activation du système électromagnétique 10, jusqu'à la position de contact (Z = 0.5 mm) avec la serge 24 du balancier, et plus généralement avec une partie déterminée de la pièce d'horlogerie selon l'application prévue pour l'actionneur. On notera que, dans une variante de réalisation où les positions axiales de l'élément mécanique et de la serge du balancier sont inversées et dans laquelle le système électromagnétique présente, lorsque ce système électromagnétique est inactif et donc au repos, un espace libre entre l'aimant permanent et la bobine, la force électromagnétique est prévue alors attractive pour actionner l'élément mécanique de sa position de repos à sa position de contact.

Selon l'invention, l'actionneur comprend en outre un élément magnétique agencé dans une position fixe relativement à l'axe de rotation du balancier du résonateur mécanique et agencé de manière à pouvoir interagir avec l'aimant permanent 12 pour engendrer entre eux une force magnétique qui s'exerce sur l'élément mécanique 22 lorsque ce dernier est dans sa position de repos et qui définit une force de rappel de cet élément mécanique vers sa position de repos sur au moins une partie initiale de la distance depuis la position de repos jusqu'à la position de contact. Dans le cas spécifique où l'actionneur est prévu en deux parties distinctes dont une incorporant la bobine est amovible, l'élément magnétique présente une position stable relativement à la bobine lorsque l'actionneur est dans une configuration fonctionnelle permettant de l'actionner. Dans les variantes particulières représentées, l'élément magnétique 26 est solidaire de la bobine 14.

La force magnétique a un sens opposé à celui de la force électromagnétique, laquelle est engendrée dans le système électromagnétique 10 lors d'une alimentation de la bobine 14, sur au moins une partie initiale de la distance depuis la position de repos jusqu'à la position de contact. Ensuite, la force magnétique a une intensité qui diminue, sur ladite au moins une partie initiale, lorsque l'élément mécanique 22 s'éloigne de la position de repos et qui est inférieure à l'intensité que présente la force électromagnétique de répulsion pour n'importe quelle position de l'élément mécanique dans ladite au moins une partie initiale. L'élément magnétique 26 est aligné sur l'axe central de l'aimant permanent 12 lorsque l'élément mécanique 22 est dans la position de repos, comme ceci est montré à la Figure 3A. Dans la première variante du premier mode de réalisation décrite ici, l'élément magnétique est formé par un élément 26 constitué d'un matériau ferromagnétique, nommé ci-après élément ferromagnétique.

Dans le premier mode de réalisation décrit ici, l'aimant permanent 12 a une forme de disque, plus généralement une forme de galette pleine. De même, l'élément magnétique 26 a une forme de disque, plus généralement une forme de galette pleine.

En l'absence d'activation du système électromagnétique, la force magnétique prévue est très efficace pour stabiliser l'organe flexible 16 et ainsi l'élément mécanique 22 dans la position de repos. L'élément magnétique 26 est agencé de manière qu'il exerce une force d'intensité croissante lorsque l'élément mécanique se rapproche de la position de repos, contrairement à la force élastique de l'organe flexible. Ainsi, sans alimentation électrique, l'organe flexible est soumis à une force magnétique qui tend à le maintenir dans sa position de repos et à le rappeler fortement vers celle-ci en cas d'une perturbation extérieure qui puisse l'éloigner momentanément de la position de repos, en limitant l'éloignement de l'élément mécanique 22 et aussi l'amplitude de rebonds éventuels que peut présenter l'organe flexible suite à un tel éloignement. En effet, la force magnétique est relativement importante lorsque l'élément mécanique 22 est dans la position de repos et à proximité de celle-ci. On verra ceci encore plus précisément dans la description ci-après d'une deuxième variante.

Aux Figures 4A et 4B est représentée une deuxième variante du premier mode de réalisation. Cette variante se distingue de la première variante par une inversion spatiale du système électromagnétique 10A du dispositif électromécanique 6A. Ainsi, l'aimant permanent 12 est porté par la lame élastique 20 du côté de son extrémité libre alors que la bobine 14 est fixée au support 18 avec l'élément magnétique 26 agencé dans l'espace intérieur de la bobine. Un avantage de cette deuxième variante réside dans le fait que la bobine ne subit ni mouvement, ni choc contre la serge 24 du balancier lorsque le système électromagnétique 10A est activé. Ceci permet de ne pas solliciter les connexions électriques de la bobine au circuit électrique de commande, et donc d'éviter une rupture de ces connexions. Par contre, cette deuxième variante est plus sensible aux champs magnétiques externes que la première variante puisque l'aimant permanent est porté par une partie mobile de l'organe flexible.

Les dimensions de l'élément magnétique sont inférieures à celles de l'aimant permanent 12. A titre d'exemple, la bobine a un diamètre extérieur égal à 2.4 mm, un diamètre intérieur de 0.9 mm et une hauteur de 0.4 mm. L'aimant permanent 12 a un diamètre de 2.0 mm et une hauteur de 1.0 mm. L'élément ferromagnétique 26 a un diamètre de 0.15 mm et une épaisseur de 0.05 mm. On notera que ces valeurs peuvent être optimisées en fonction du type d'aimant sélectionné, de la distance entre l'aimant permanent et l'élément ferromagnétique, des impulsions électriques que fournit le circuit électrique de commande au système électromagnétique, de la dynamique souhaitée pour l'élément mécanique 22 et d'autres paramètres encore. Il est important de trouver une taille de l'élément magnétique 26 et un positionnement de celui-ci relativement à l'aimant permanent pour obtenir une force d'attraction qui soit assez forte pour bien stabiliser l'organe flexible, en particulier son élément mécanique, dans la position de repos en l'absence d'activation du système électromagnétique, tout en assurant que la force électromagnétique soit suffisante pour vaincre la force magnétique et pour permettre un mouvement de l'élément mécanique tel que ce dernier puisse exercer une force d'une certaine intensité sur la serge du balancier contre laquelle il doit pouvoir exercer momentanément une pression suffisante pour effectuer une impulsion de freinage dans une application de régulation de la marche de la montre.

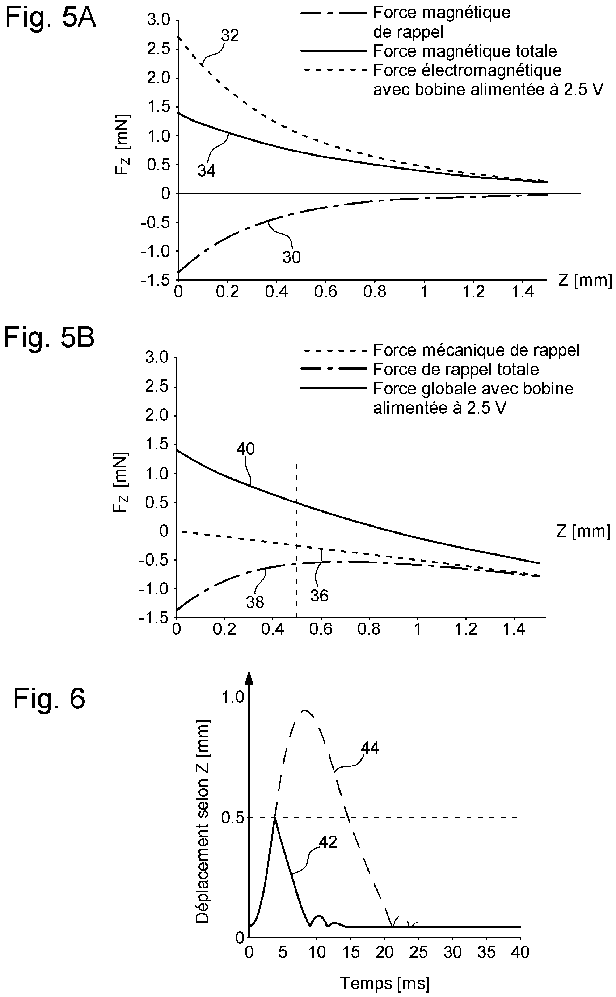

Pour la deuxième variante décrite ici, avec des dimensions pour le système électromagnétique et l'élément ferromagnétique environ égales à celles données en exemple précédemment, la Figure 5A donne a) la courbe 30 de la force magnétique engendrée entre l'aimant permanent 12 et l'élément ferromagnétique 26 en fonction d'un déplacement de l'élément mécanique selon l'axe Z, cette force définissant une force magnétique de rappel sur toute la plage de déplacement représentée et en particulier sur la distance que peut parcourir l'élément mécanique 22 entre la position de repos (Z = 0.0 mm) et la position de contact (Z = 0.5 mm) ; b) la courbe 32 de la force électromagnétique, avec la bobine 14 alimentée sous une tension de 2.5 V, en fonction du déplacement de l'élément mécanique selon l'axe Z ; c) la courbe 34 de la force magnétique totale, résultant de l'addition de la force électromagnétique et de la force magnétique de rappel, en fonction du déplacement de l'élément mécanique selon l'axe Z.

La Figure 5B introduit la force mécanique de rappel, définie par la force exercée par la lame élastique 20 lorsqu'elle s'écarte de sa position de repos, qui est donnée par la courbe 36, laquelle est déterminée par le coefficient d'élasticité de la lame élastique. Ensuite, la courbe 38 représente la force de rappel totale, résultant de l'addition de la force magnétique (courbe 30) et de la force mécanique de rappel (courbe 36), en fonction du déplacement de l'élément mécanique selon l'axe Z. On observe que la force de rappel totale augmente en intensité depuis la position de contact jusqu'à la position de repos où elle est maximale, et ceci grâce à l'élément ferromagnétique. Finalement, la courbe 40 donne la force globale qui s'exerce sur l'organe flexible 16, au niveau de l'élément mécanique 22, en fonction du déplacement de l'élément mécanique selon l'axe Z. Bien que cette force globale change de signe mathématique et donc de sens sur la plage de déplacement représentée, elle demeure toutefois positive sur toute la distance entre la position de repos et la position de contact prévue.

Les graphes donnés à la Figure 5B concernent le cas particulier ou l'élément élastique 20 est entièrement détendu lorsque l'organe flexible est dans la position de repos (Z = 0.0), de sorte que la force mécanique dans cette position est nulle. Dans d'autres variantes, une précontrainte de l'élément élastique est prévue dans la position de repos. Une telle précontrainte peut être prévue soit positive, de sorte que la force mécanique de rappel (force élastique) est entraînante sur une partie initiale de la distance depuis la position de repos jusqu'à la position de contact, soit négative de sorte que la force mécanique de rappel est supérieure à celle intervenant dans la variante représentée sur toute ladite distance. Une précontrainte de l'organe flexible au repos permet ainsi de régler la force de rappel totale, notamment pour la position de repos et à proximité de celle-ci, et donc la quantité d'énergie à fournir à l'organe flexible via le système électromagnétique lors d'une impulsion de freinage. On comprend que ce réglage permet de déterminer la dynamique de l'élément mécanique lorsqu'il est actionné via une impulsion électrique fournie par le circuit électrique de commande à la bobine 14. La Figure 6 donne le déplacement selon l'axe Z de l'élément mécanique 22 lors d'une impulsion électrique d'environ 4 ms activant le système électromagnétique. La courbe 42 montre le cas réel avec l'élément 22 qui vient buter contre la serge 24 du balancier pour lui fournir une impulsion de freinage, alors que la courbe 44 montre le cas virtuel correspondant en l'absence du balancier. La durée de chaque impulsion électrique peut être déterminée en fonction de l'intensité du choc souhaité entre l'élément mécanique 22 et la serge 24 du balancier. De plus, cette durée peut être prévue supérieure au temps du déplacement de l'élément mécanique entre la position de repos et la position de contact pour prolonger la durée du contact entre l'élément mécanique 22 et la serge 24.

Dans deux autres variantes du premier mode de réalisation, l'élément ferromagnétique dans les deux variantes décrites précédemment est remplacé par un deuxième aimant permanent présentant un axe magnétique parallèle à celui de l'aimant permanent 12 et une même polarité que cet aimant. Ainsi le premier aimant 12 et le deuxième aimant pour la stabilisation de l'organe flexible en position de repos sont en attraction magnétique pour toute position de l'élément mécanique entre la position de repos, y compris, et la position de contact. De préférence, le deuxième aimant permanent a une forme de galette pleine, notamment une forme de disque.

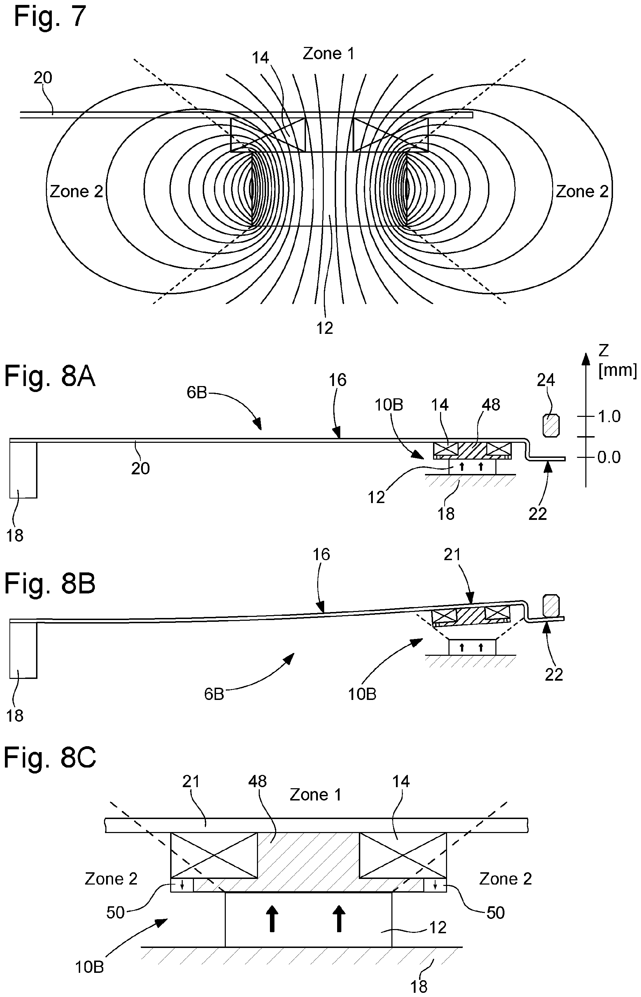

La Figure 7 est une introduction au deuxième mode de réalisation qui sera décrit ci-après. Cette figure montre le système électromagnétique 10 décrit précédemment. Les lignes de champ magnétique générées par l'aimant permanent 12 sont représentées, ces lignes de champ magnétique définissant deux zones, Zone 1 et Zone 2, pour un deuxième aimant placé à la périphérie de l'aimant 12 et présentant un axe magnétique de même direction. Si les deux aimants ont une même polarité selon ladite direction (axe Z), alors ils présentent une attraction magnétique dans la Zone 1 et une répulsion magnétique dans la Zone 2. Cette observation est à la base du deuxième mode de réalisation représenté aux Figures 8A à 8C.

En référence aux figures 8A à 8C, une variante d'un deuxième mode de réalisation est proposée dans laquelle l'élément magnétique de stabilisation de la position de repos de l'organe flexible 16 est un deuxième aimant permanent 50 qui présente une forme annulaire définissant un cercle central. Pour une section transversale rectangulaire comme représentée aux figures, le diamètre de ce cercle central est classiquement donné par l'intersection des deux diagonales de cette section transversale. Les références identiques à celles du premier mode de réalisation concernent des éléments ou parties qui sont semblables ou similaires aux éléments ou parties correspondantes de ce premier mode de réalisation.

Ce deuxième mode de réalisation se distingue du précédent essentiellement par le fait que l'élément magnétique du dispositif électromécanique 6B est un deuxième aimant permanent, qui présente une forme annulaire définissant un cercle central, ou par le fait que cet élément magnétique est constitué par une pluralité d'aimants permanents agencés le long d'un cercle géométrique. Le cercle central a un diamètre qui est supérieur au diamètre extérieur du premier aimant permanent et il est, lorsque l'organe flexible est dans la position de repos (Figures 8A et 8C), centré sur l'axe central du premier aimant permanent 12. Le diamètre du cercle central est sélectionné de sorte que la force magnétique entre le premier aimant permanent 12 et le deuxième aimant permanent annulaire 50 présente une inversion de sens lors d'un mouvement de l'élément mécanique 22 depuis la position de repos jusqu'à la position de contact avec le balancier 24. Comme on l'observe aux Figures 8C et 8B, l'aimant permanent annulaire 50 est situé dans la Zone 2 lorsque l'organe flexible est au repos, de sorte que la force magnétique entre les deux aimants est en attraction, alors que dans la position de contact, l'aimant permanent annulaire est dans la Zone 1 de sorte que les deux aimants sont alors en répulsion magnétique.

Ainsi, dans la position de repos, l'aimant permanent annulaire 50 joue bien son rôle de rappel vers la position de repos. Par contre, lors d'une activation du système électromagnétique, cet aimant annulaire traverse la frontière entre la Zone 2 et la Zone 1 et ainsi la force magnétique devient positive et par conséquent une force d'entraînement, ce qui modifie la dynamique du mouvement de l'élément mécanique 22 relativement au premier mode de réalisation. On remarquera que la position selon l'axe Z de l'aimant annulaire 50 peut aisément être ajustée. Il est en particulier possible que le cercle central soit au niveau de la surface supérieure du premier aimant 12, voire en dessous. Une pièce 48 en matériau amagnétique forme un noyau de la bobine 14 et un flasque qui est entouré par l'aimant 50. Cette pièce 48 subit le choc entre l'organe flexible 16 et l'aimant 12. On peut ainsi sélectionner son matériau pour préserver le premier aimant, ce matériau présentant de préférence une bonne capacité d'absorption d'énergie lors du choc entre la pièce 48 et le premier aimant lors d'un retour de l'élément mécanique vers la position de repos après qu'il ait buter contre la serge 24 du balancier lors d'une impulsion de freinage.

Dans une variante non représentée, l'aimant annulaire 50 est remplacé par une pluralité d'aimants permanents distincts qui sont agencés le long d'un cercle géométrique. Dans ce cas, c'est le cercle géométrique qui a un diamètre supérieur au diamètre extérieur du premier aimant permanent 12 et qui est, lorsque l'organe flexible est dans la position de repos, centré sur l'axe central du premier aimant permanent. Le diamètre du cercle géométrique est sélectionné de sorte que la force magnétique entre le premier aimant permanent et la pluralité d'aimants permanents présente une inversion de sens lors du mouvement de l'élément mécanique entre la position de repos et la position de contact. Cette variante présente l'avantage de ne pas devoir produire un aimant annulaire de petite section transversale. Dans un premier cas, la pluralité d'aimants peut être constituée de deux petits aimants agencés de manière diamétralement opposées et orientés de préférence orthogonalement à la direction de la partie terminale de la lame élastique 20 reliée au disque 21 supportant la bobine et la pièce 48. Dans un deuxième cas, il est prévu quatre aimants répartis régulièrement le long du cercle géométrique. Ces aimants peuvent être logés dans des cavités du flasque de la pièce de contact avec le premier aimant.

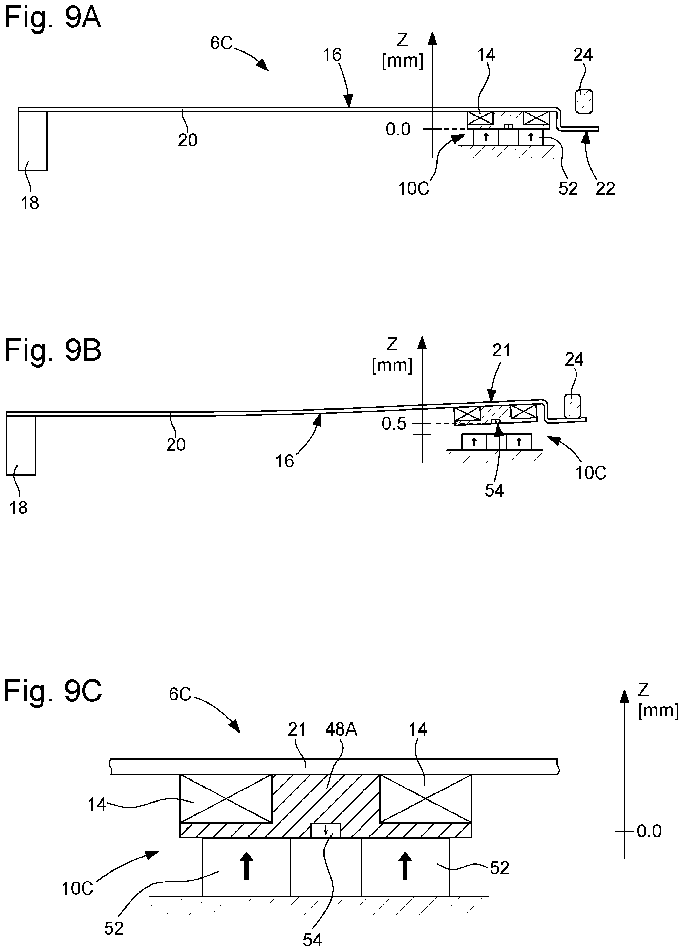

En référence aux Figures 9A à 11B, on décrira ci-après un troisième mode de réalisation de l'invention. Les références déjà décrites précédemment ne seront pas décrites à nouveau en détails ici. Ce troisième mode de réalisation est caractérisé par un système électromagnétique 10C dont l'aimant permanent 52, dit premier aimant permanent ou premier aimant, a une forme annulaire et par un élément magnétique constitué par un aimant permanent 54, dit deuxième aimant permanent ou deuxième aimant, ayant une forme de galette pleine, notamment une forme de disque. Le deuxième aimant est agencé de manière à être aligné sur un axe central du premier aimant lorsque l'élément mécanique 22 est dans la position de repos (Figures 9A et 9C). Ce deuxième aimant est placé dans un logement d'un support 48A formant un noyau pour la bobine 14 et en outre un flasque qui recouvre la surface inférieure de cette bobine, comme dans le deuxième mode de réalisation. La position zéro selon l'axe Z est définie par la surface supérieure du premier aimant et la position de repos de l'organe flexible 16 correspond à un positionnement du deuxième aimant, qui est mobile de manière synchrone avec l'élément mécanique 22, dans lequel sa surface inférieure est sensiblement à la position zéro. La Figure 9B montre le dispositif électromécanique 6C de l'actuateur considéré dans une situation / un état où l'organe flexible, en particulier son élément mécanique, est dans la position de contact avec le balancier.

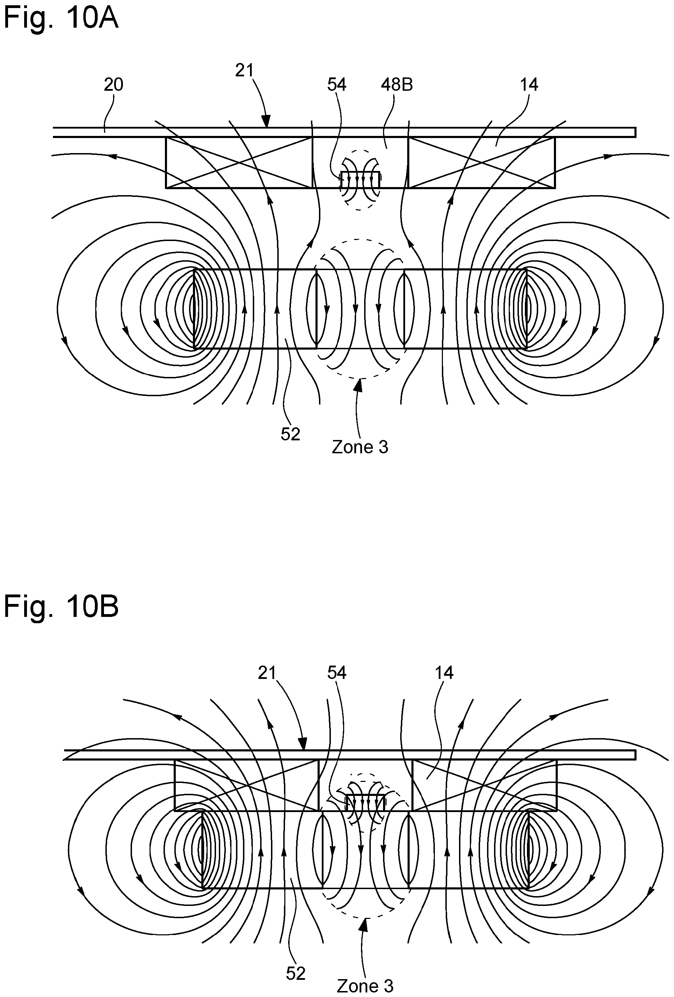

Ensuite, le deuxième aimant 54 est agencé de sorte que la force magnétique entre le premier aimant annulaire 52 et ce deuxième aimant présente une inversion de sens lors d'un mouvement de l'élément mécanique 22 depuis sa position de repos jusqu'à la position de contact avec la serge 24 du balancier, en réponse à une impulsion électrique fournie à la bobine 14 par le circuit électrique de commande pour engendrer une impulsion de freinage. Aux Figures 10A et 10B est représenté partiellement une deuxième variante de réalisation qui présente un agencement des premier et deuxième aimants qui est semblable à celui de la première variante donnée aux Figures 9A à 9C. Ainsi l'interaction entre ces deux aimants est identique dans les deux variantes. La seule différence réside dans le fait que le support 48B du deuxième aimant dans la deuxième variante forme seulement un noyau amagnétique pour la bobine 14 alors que le support 48A de la première variante présente en outre un flasque recouvrant la surface inférieure de la bobine. Aux Figures 10A et 10B, les lignes de champ magnétique du premier aimant annulaire et du deuxième aimant ont été représentées partiellement. L'espace intérieur du premier aimant 52 définit un vide central de forme cylindrique. La forme annulaire du premier aimant a ceci de particulier que ses lignes de champ magnétique à l'intérieur du vide central cylindrique présentent un sens opposé à celui du champ magnétique dans l'aimant lui-même. Ainsi, dans une Zone 3 englobant l'espace intérieur et deux zones complémentaires s'étendant respectivement de part et d'autre de cet espace intérieur, le sens du champ magnétique généré par le premier aimant est opposé, selon l'axe Z, au sens du champ magnétique de ce premier aimant dans une zone prolongeant la Zone 3 au-dessus dudit espace intérieur.

La Figure 10A montre partiellement le dispositif électromécanique 6C, en particulier le disque 21 de l'organe flexible 16, le système électromagnétique 10C et l'élément magnétique additionnel 54, dans une situation correspondant à celle de la Figure 9B où l'organe flexible, en particulier son élément mécanique, est dans la position de contact. Dans cet état, le deuxième aimant, qui présente une polarité opposée à celle du premier aimant annulaire (c'est-à-dire entre la surface inférieure et la surface supérieure de ce premier aimant), subit une répulsion magnétique. La Figure 10B montre partiellement le dispositif électromécanique 6C dans une situation correspondante à celle des Figures 9A et 9C où l'organe flexible est dans sa position de repos. Dans cet état, le deuxième aimant 54 est situé dans la Zone 3 et il subit alors une attraction magnétique de la part du premier aimant annulaire.

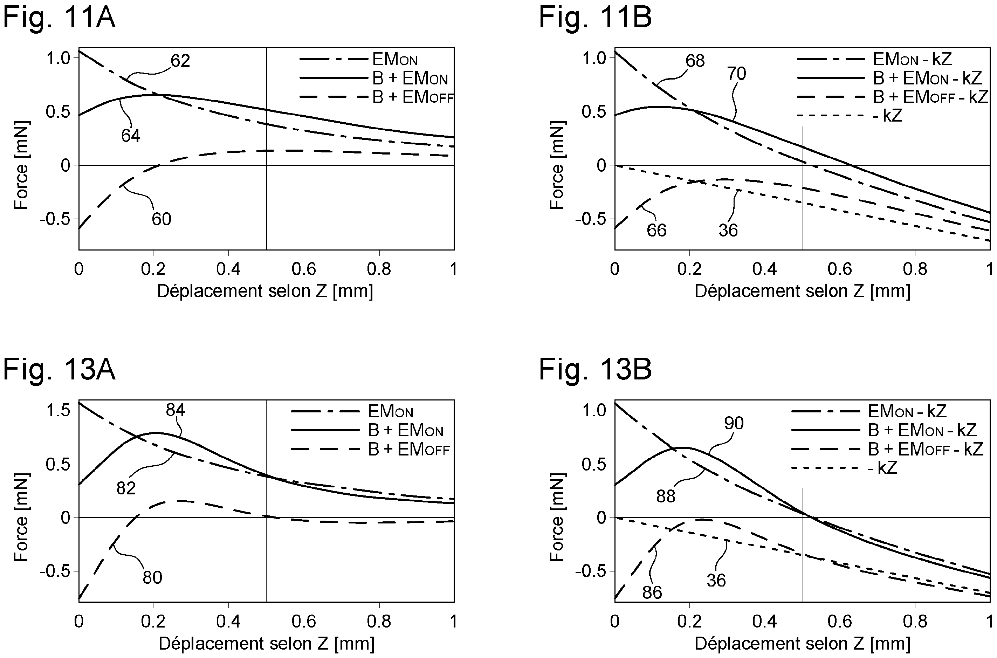

A la Figure 11A est donnée la courbe 60 de la force magnétique en fonction du déplacement de l'élément magnétique 54 depuis sa position zéro, correspondant à la position de repos de l'organe flexible / l'élément mécanique et dans laquelle sa surface inférieure est confondue avec la surface supérieure du premier aimant qui définit cette position zéro, jusqu'à la position de contact de l'élément mécanique 22 avec le balancier. A noter que l'interaction magnétique entre les deux aimants est indiquée par 'B' dans les légendes aux Figures 11A, 11B, 13A et 13B, alors que 'EM' indique l'interaction électromagnétique entre la bobine et le premier aimant 52, laquelle est soit activée ('ON'), soit désactivée ('OFF'). On voit l'inversion du sens de la force magnétique sur le graphe de la Figure 11A, la courbe 60 interceptant l'axe Z=0. On remarque que l'intensité de la force magnétique est relativement forte pour la position de repos (Z=0), de sorte que le deuxième aimant joue correctement son rôle de stabilisation de l'organe flexible dans la position de repos, puis elle diminue rapidement pour être égale à zéro juste au-dessus de 0.2 mm. Ensuite, après le passage par la valeur zéro, la force magnétique et positive mais son intensité reste relativement faible. Cependant, sur la distance de déplacement prévue (0.5 mm), la quantité d'énergie nécessaire pour vaincre la force magnétique est significativement inférieure à celle nécessaire dans les deux premiers modes de réalisation. L'inversion de la force magnétique au cours d'un mouvement de l'élément mécanique 22 entre la position de repos et la position de contact avec la serge 24 du balancier change donc la dynamique du mouvement de cet élément mécanique lors d'une impulsion électrique fournie à la bobine 14, laquelle engendre une force électromagnétique donnée par la courbe 62. La force magnétique totale (addition de la force magnétique et de la force électromagnétique lors d'une activation du système électromagnétique 10C) est représentée par la courbe 64. On observe dans l'exemple donné que cette force magnétique totale varie relativement peu sur la distance de déplacement de l'élément magnétique.

A la Figure 11B sont représentées diverses forces en fonction du déplacement de l'élément magnétique 54 en prenant en considération la force mécanique de l'élément élastique 20 formant l'organe flexible et dont la force de rappel mécanique est donnée par la courbe 36. La courbe 66 donne une force de rappel totale égale à la somme de la force magnétique et de la force mécanique. La courbe 68 correspond à la somme de la force électromagnétique et de la force de rappel mécanique. Finalement, la courbe 70 donne la courbe de la force globale pour l'ensemble des forces en présence, avec le système électromagnétique alimenté, en fonction du déplacement de l'élément magnétique, respectivement de l'élément mécanique (avec une petite variation d'échelle selon l'axe Z). On observe que les divers éléments intervenant premièrement dans la force de rappel totale (courbe 66) et ensuite dans la force globale (courbe 70) sont sélectionnés et agencés de sorte que la force globale est positive sur toute la distance de déplacement et que la force de rappel totale est négative sur toute la distance de déplacement, c'est-à-dire pour n'importe quelle position entre la position de repos et la position de contact. Concernant cette dernière condition, en d'autres termes, le premier aimant annulaire, le deuxième aimant permanent et l'élément élastique sont configurés et agencés de manière que la somme de la force mécanique de rappel et de la force magnétique présente, sur toute la distance que peut parcourir l'élément mécanique 22, un sens opposé au sens du mouvement de cet élément mécanique depuis la position de repos jusqu'à la position de contact, de sorte à former sur toute cette distance une force totale de rappel de l'élément mécanique vers la position de repos.

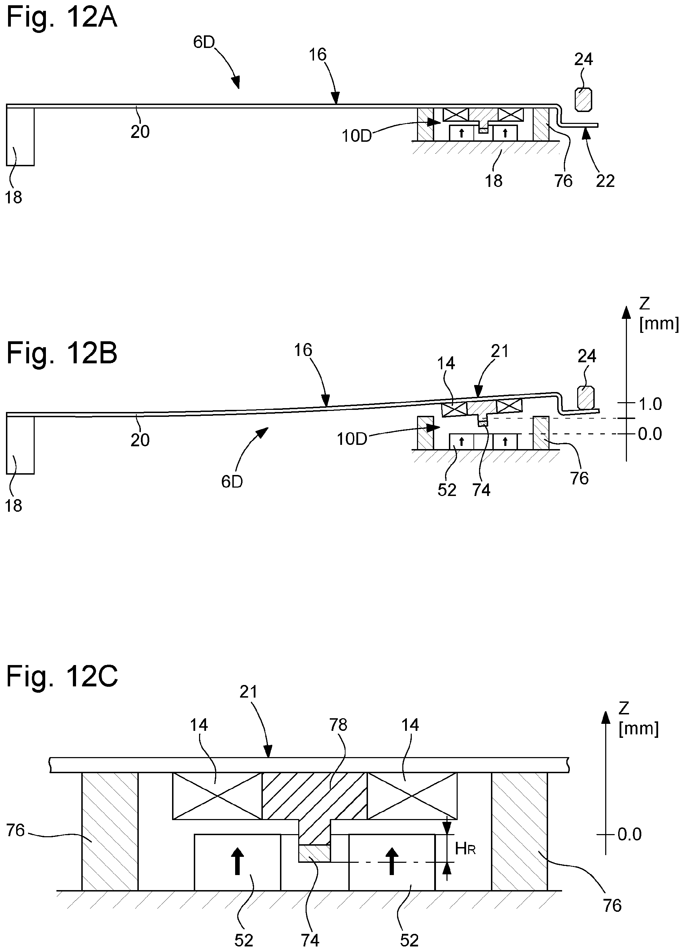

En référence aux Figures 12A à 12C et aux Figures 13A et 13B, on décrira finalement un quatrième mode de réalisation de l'invention. Les références déjà décrites en détails précédemment ne seront décrites à nouveau. Ce quatrième mode de réalisation se distingue essentiellement du mode de réalisation précédent par le fait que l'élément magnétique 74 du dispositif électromécanique est constitué d'un matériau ferromagnétique et que cet élément ferromagnétique 74 est positionné selon l'axe Z a un niveau différent. En outre, afin d'éviter des chocs entre l'aimant annulaire 52 et la bobine 14 lors d'impulsions électriques fournies successivement à la bobine pour engendrer une pluralité d'impulsions de freinage, un tube circulaire 76 est prévu autour du système électromagnétique 10D dans la position de repos. Le tube cylindrique est agencé de manière que le disque 21 de l'organe flexible est en appui contre la surface supérieure de ce tube cylindrique lorsque l'organe flexible est au repos, la hauteur du tube cylindrique étant sélectionnée de sorte que la bobine 14 se trouve à distance de l'aimant permanent 52 dans la position de repos de l'organe flexible.

L'élément ferromagnétique 74 a une forme de galette pleine, notamment une forme de disque, et il est agencé de manière à être aligné sur un axe central de l'aimant permanent annulaire lorsque l'élément mécanique est dans la position de repos. L'élément ferromagnétique est fixé à une partie saillante d'un support 78 formant un noyau de la bobine 14. Comme on peut l'observer à la Figure 12C, l'élément ferromagnétique est agencé à l'intérieur de l'espace intérieur de l'aimant permanent annulaire lorsque l'organe flexible est dans sa position de repos et il présente ainsi un offset négatif H_{R} relativement au deuxième aimant permanent du mode de réalisation précédent, c'est-à-dire que sa surface inférieure est située en dessous de la position Z=0 qui est définie, comme dans le troisième mode réalisation, par le niveau de la surface supérieure de l'aimant permanent 52. De manière générale, l'élément ferromagnétique est agencé de manière à être positionné au moins partiellement dans un espace intérieur de l'aimant permanent annulaire 52 lorsque l'élément mécanique est dans la position de repos.

Aux Figures 13A et 13B sont donnés deux graphes avec des courbes représentant les mêmes forces, en fonction du déplacement de l'élément ferromagnétique, que dans les graphes des Figures 11A et 11B. La courbe 80 concerne la force magnétique entre l'aimant permanent annulaire et l'élément ferromagnétique. On observe que le positionnement de l'élément ferromagnétique dans l'espace intérieur de l'aimant permanent annulaire, lorsque l'organe flexible est au repos, permet d'avoir un sens négatif pour la force magnétique, et donc une force de rappel magnétique, sur une première partie de la distance que peut parcourir l'élément ferromagnétique, respectivement l'élément mécanique, depuis la position de repos de l'organe flexible et une intensité de cette force magnétique qui est relativement importante lorsque cet organe flexible est dans sa position de repos (Z=0). La courbe 82 de la force électromagnétique est identique à la courbe 62. La courbe 84 représente la force magnétique totale (addition de la force magnétique et de la force électromagnétique lors d'une activation du système électromagnétique 10D). On observe dans l'exemple donné que cette force magnétique totale varie passablement sur la distance de déplacement de l'élément magnétique, mais elle reste positive et relativement importante sur toute la distance entre la position de repos et la position de contact (Z=0.5 mm).

A la Figure 13B sont représentées diverses forces en fonction du déplacement de l'élément ferromagnétique 74, en prenant en considération la force mécanique de l'élément élastique 20 formant l'organe flexible et dont la force de rappel mécanique est donnée par la courbe 36. La courbe 86 donne une force de rappel totale égale à la somme de la force magnétique et de la force mécanique. La courbe 88 correspond à la somme de la force électromagnétique et de la force de rappel mécanique. Finalement, la courbe 90 donne la courbe de la force globale pour l'ensemble des forces en présence, avec le système électromagnétique 10D alimenté, en fonction du déplacement de l'élément ferromagnétique, respectivement de l'élément mécanique (avec une petite variation d'échelle selon l'axe Z). On observe que les divers éléments intervenant premièrement dans la force de rappel totale (courbe 86) et ensuite dans la force globale (courbe 90) sont sélectionnés et agencés de sorte que la force globale est positive sur toute la distance de déplacement et que la force de rappel totale est négative pour n'importe quelle position de l'élément ferromagnétique entre la position de repos et la position de contact de l'élément mécanique. En d'autres termes, selon cette dernière condition qui concerne une variante préférée, l'aimant permanent annulaire 52, l'élément ferromagnétique 74 et l'élément élastique 20 sont configurés et agencés de manière que la somme de la force mécanique de rappel et de la force magnétique présente, sur toute la distance que peut parcourir l'élément mécanique 22, un sens opposé au sens du mouvement de cet élément mécanique depuis la position de repos jusqu'à la position de contact, de sorte à former sur toute ladite distance de déplacement une force totale de rappel de l'élément mécanique vers la position de repos. On remarquera qu'il n'est pas nécessaire, bien que préféré, que la force globale soit positive jusqu'à la position de contact. En effet, étant donné la dynamique du mouvement de l'élément mécanique, ce dernier arrive à la position de contact avec une certaine énergie cinétique de sorte qu'une force globale légèrement négative sur une partie finale de ladite distance de déplacement ne pose pas un problème majeur. Finalement, bien que préféré, il n'est pas indispensable que la force de rappel totale reste négative sur toute ladite distance de déplacement, et qu'elle perde donc sur un certain tronçon intermédiaire, son caractère de force de rappel. En effet, après un choc entre l'élément mécanique et le balancier à la position de contact, l'élément mécanique 22 repart en sens inverse en direction de la position de repos avec une certaine énergie. De plus, si la force de rappel totale est significative sur ladite partie finale de la distance de placement, alors l'élément mécanique emmagasine une certaine énergie cinétique qui peut lui permettre de traverser un certain tronçon intermédiaire où la force de rappel totale aurait changé momentanément de sens.

## Revendications

1. Pièce d'horlogerie (2) incorporant un actionneur formé d'un dispositif électromécanique (6 ; 6A ; 6B ; 6C ; 6D), lequel comprend un système électromagnétique (10 ; 10A ; 10B ; 10C ; 10D) ainsi qu'un élément mécanique (22) qui est mobile en translation et associé au système électromagnétique, et d'un circuit électrique de commande (8), le système électromagnétique étant formé d'un aimant permanent (12 ; 52) et d'une bobine (14) dont l'un parmi les deux est porté par un organe flexible (16) du dispositif électromécanique et l'autre par un support (18) de cet organe flexible, ledit élément mécanique étant formé par ledit organe flexible et l'actionneur étant agencé de manière à permettre, en réponse à un signal électrique d'activation généré par le circuit électrique de commande et fourni à la bobine pour engendrer une force électromagnétique entre cette bobine et ledit aimant permanent, un mouvement de l'élément mécanique depuis une position de repos, dans laquelle il est prévu que l'élément mécanique demeure en l'absence d'une activation du système électromagnétique, jusqu'à une position de contact avec une partie déterminée (24) de la pièce d'horlogerie ; dans laquelle ledit organe flexible est formé au moins partiellement par un élément élastique (20) qui est agencé de manière à engendrer une force mécanique de rappel de l'élément mécanique en direction de ladite position de repos sur au moins une majeure partie de la distance que peut parcourir l'élément mécanique, lorsque le circuit électrique de commande génère ledit signal électrique d'activation, entre la position de repos et la position de contact, cette position de contact terminant ladite au moins une majeure partie de ladite distance ; l'actionneur comprenant en outre un élément magnétique (26 ; 50 ; 54 ; 74) agencé de manière à pouvoir interagir avec ledit aimant permanent (12 ; 52) pour engendrer entre eux une force magnétique qui s'exerce sur l'élément mécanique lorsque ce dernier est dans la position de repos, cette force magnétique ayant un sens opposé à celui de ladite force électromagnétique sur au moins une partie initiale de ladite distance depuis la position de repos et une intensité qui diminue, sur ladite au moins une partie initiale, lorsque l'élément mécanique s'éloigne de la position de repos et qui est inférieure à l'intensité que présente ladite force électromagnétique pour n'importe quelle position dudit élément mécanique dans ladite au moins une partie initiale.

2. Pièce d'horlogerie selon la revendication 1, **caractérisée en ce que** ledit élément magnétique (26 ; 74) est constitué d'un matériau ferromagnétique.

3. Pièce d'horlogerie selon la revendication 1, dans laquelle ledit aimant permanent est un premier aimant, **caractérisée en ce que** ledit élément magnétique (50 ; 54) est formé par un deuxième aimant permanent agencé en attraction magnétique avec le premier aimant lorsque ledit élément mécanique (22) est dans la position de repos.

4. Pièce d'horlogerie selon la revendication 2, **caractérisée en ce que** ledit aimant permanent (12) a une forme de galette pleine, notamment une forme de disque ; et **en ce que** ledit élément magnétique est agencé de manière à être aligné sur un axe central de l'aimant permanent lorsque l'élément mécanique est dans la position de repos.

5. Pièce d'horlogerie selon la revendication 3, **caractérisée en ce que** le premier aimant permanent (12) a une forme de galette pleine, notamment une forme de disque ; et **en ce que** ledit élément magnétique est agencé de manière à être aligné sur un axe central de du premier aimant permanent lorsque l'élément mécanique est dans la position de repos.

6. Pièce d'horlogerie selon la revendication 4, **caractérisée en ce que** ledit élément ferromagnétique (26 ; 74) a une forme de galette pleine, notamment une forme de disque.

7. Pièce d'horlogerie selon la revendication 5, **caractérisée en ce que** le deuxième aimant permanent (54) a une forme de galette pleine, notamment une forme de disque.

8. Pièce d'horlogerie selon la revendication 5, **caractérisée en ce que** ledit élément magnétique (50) est constitué par le deuxième aimant permanent, qui présente une forme annulaire définissant un cercle central, ou par une pluralité d'aimants permanents agencés le long d'un cercle géométrique ; **en ce que** ledit cercle central ou ledit cercle géométrique a un diamètre qui est supérieur au diamètre extérieur du premier aimant permanent (12) et est, lorsque l'organe flexible est dans la position de repos, centré sur l'axe central du premier aimant permanent ; et **en ce que** le diamètre du cercle central ou du cercle géométrique est sélectionné de sorte que ladite force magnétique entre le premier aimant permanent et le deuxième aimant permanent, respectivement la pluralité d'aimants permanents présente une inversion de sens lors dudit mouvement dudit élément mécanique (22) depuis la position de repos jusqu'à la position de contact.

9. Pièce d'horlogerie selon la revendication 2, **caractérisée en ce que** ledit aimant permanent (52) a une forme annulaire.

10. Pièce d'horlogerie selon la revendication 3, **caractérisée en ce que** le premier aimant permanent (52) a une forme annulaire.

11. Pièce d'horlogerie selon la revendication 9, **caractérisée en ce que** ledit élément ferromagnétique (74) a une forme de galette pleine, notamment une forme de disque ; et **en ce que** cet élément ferromagnétique est agencé de manière à être aligné sur un axe central dudit aimant permanent lorsque l'élément mécanique est dans sa position de repos.

12. Pièce d'horlogerie selon la revendication 11, **caractérisée en ce que** l'élément ferromagnétique est agencé de manière à être positionné au moins partiellement dans un espace intérieur de l'aimant permanent annulaire lorsque ledit élément mécanique est dans la position de repos.

13. Pièce d'horlogerie selon la revendication 11 ou 12, **caractérisée en ce que** l'aimant permanent (52), l'élément ferromagnétique (74) et l'élément élastique (20) sont configurés et agencés de manière que la somme de ladite force mécanique de rappel et de ladite force magnétique présente, sur toute ladite distance que peut parcourir ledit élément mécanique, un sens opposé au sens dudit mouvement de cet élément mécanique depuis la position de repos jusqu'à la position de contact, de sorte à former sur toute ladite distance une force totale de rappel de l'élément mécanique vers la position de repos.

14. Pièce d'horlogerie selon la revendication 10, **caractérisée en ce que** le deuxième aimant permanent (54) a une forme de galette pleine, notamment une forme de disque ; et **en ce que** le deuxième aimant permanent est agencé de manière à être aligné sur un axe central du premier aimant permanent lorsque l'élément mécanique est dans la position de repos.

15. Pièce d'horlogerie selon la revendication 14, **caractérisée en ce que** le deuxième aimant permanent est agencé de sorte que ladite force magnétique entre le premier aimant permanent (52) et le deuxième aimant permanent (54) présente une inversion de sens lors dudit mouvement dudit élément mécanique (22) depuis la position de repos jusqu'à la position de contact.

16. Pièce d'horlogerie selon la revendication 15, **caractérisée en ce que** le premier aimant permanent, le deuxième aimant permanent et l'élément élastique (20) sont configurés et agencés de manière que la somme de ladite force mécanique de rappel et de ladite force magnétique présente, sur toute ladite distance que peut parcourir ledit élément mécanique (22), un sens opposé au sens dudit mouvement de cet élément mécanique depuis la position de repos jusqu'à la position de contact, de sorte à former sur toute ladite distance une force totale de rappel de l'élément mécanique vers la position de repos.

## Patentansprüche

1. Uhrmachereistück (2), das ein Wirkglied beinhaltet, das aus einer elektromechanischen Vorrichtung (6; 6A; 6B; 6C; 6D), die ein elektromagnetisches System (10; 10A; 10B; 10C; 10D), sowie ein mechanisches Element (22) umfasst, das translatorisch beweglich und dem elektromagnetischen System zugeordnet ist, und einem elektrischen Steuerkreis (8) gebildet ist, wobei das elektromagnetische System durch einen Permanentmagneten (12; 52) und eine Spule (14) gebildet wird, von denen eines von den beiden von einem flexiblen Organ (16) der elektromechanischen Vorrichtung, und das andere von einem Träger (18) dieses flexiblen Organs getragen wird, wobei das mechanische Element durch das flexible Organ gebildet wird und das Wirkglied angeordnet ist, um als Reaktion auf ein elektrisches Aktivierungssignal, das von der elektrischen Steuerschaltung erzeugt, und der Spule bereitgestellt wird, um eine elektromagnetische Kraft zwischen dieser Spule und dem Permanentmagneten zu ergeben, eine Bewegung des mechanischen Elements aus einer Ruheposition, in der vorgesehen ist, dass das mechanische Element in Abwesenheit einer Aktivierung des elektromagnetischen Systems verbleibt, bis zu einer Kontaktposition mit einem bestimmten Teil (24) des Uhrmachereistücks zu ermöglichen; wobei das flexible Organ zumindest teilweise durch ein elastisches Element (20) gebildet wird, das angeordnet ist, um eine mechanische Rückstellkraft des mechanischen Elements in Richtung der Ruheposition über zumindest einen Hauptteil der Distanz zu ergeben, die das mechanische Element, wenn die elektrische Steuerschaltung das elektrische Aktivierungssignal erzeugt, zwischen der Ruheposition und der Kontaktposition zurücklegen kann, wobei diese Kontaktposition den zumindest einen Hauptteil der Distanz beendet;
wobei das Wirkglied weiter ein magnetisches Element (26; 50; 54; 74) umfasst, das angeordnet ist, um mit dem Permanentmagneten (12; 52) zusammenwirken zu können, um dazwischen eine magnetische Kraft zu ergeben, die auf das mechanische Element einwirkt, wenn sich dieses letztere in der Ruheposition befindet, wobei diese magnetische Kraft eine entgegengesetzte Richtung zu jener der elektromagnetischen Kraft über mindestens einen anfänglichen Teil der Distanz aus der Ruheposition aufweist, und eine Intensität, die über den mindestens einen anfänglichen Teil abnimmt, wenn sich das mechanische Element aus der Ruheposition entfernt, und die geringer ist als die Intensität, die die elektromagnetische Kraft für jede beliebige Position des mechanischen Elements in dem mindestens einen anfänglichen Teil aufweist.

2. Uhrmachereistück nach Anspruch 1, **dadurch gekennzeichnet, dass** das magnetische Element (26; 74) aus einem ferromagnetischen Werkstoff besteht.

3. Uhrmachereistück nach Anspruch 1, wobei der Permanentmagnet ein erster Magnet ist, **dadurch gekennzeichnet, dass** das magnetische Element (50; 54) durch einen zweiten Permanentmagneten gebildet wird, der in magnetischer Anziehung mit dem ersten Magneten angeordnet ist, wenn sich das mechanische Element (22) in der Ruheposition befindet.

4. Uhrmachereistück nach Anspruch 2, **dadurch gekennzeichnet, dass** der Permanentmagnet (12) eine Form einer vollen Rolle, insbesondere eine Scheibenform, aufweist; und dadurch, dass das magnetische Element angeordnet ist, um auf einer Mittelachse des Permanentmagneten ausgerichtet zu sein, wenn sich das mechanische Element in der Ruheposition befindet.

5. Uhrmachereistück nach Anspruch 3, **dadurch gekennzeichnet, dass** der erste Permanentmagnet (12) eine Form einer vollen Rolle, insbesondere eine Scheibenform, aufweist; und dadurch, dass das magnetische Element angeordnet ist, um auf einer Mittelachse des ersten Permanentmagneten ausgerichtet zu sein, wenn sich das mechanische Element in der Ruheposition befindet.

6. Uhrmachereistück nach Anspruch 4, **dadurch gekennzeichnet, dass** das ferromagnetische Element (26; 74) eine Form einer vollen Rolle, insbesondere eine Scheibenform, aufweist.

7. Uhrmachereistück nach Anspruch 5, **dadurch gekennzeichnet, dass** der zweite Permanentmagnet (54) eine Form einer vollen Rolle, insbesondere eine Scheibenform, aufweist.

8. Uhrmachereistück nach Anspruch 5, **dadurch gekennzeichnet, dass** das magnetische Element (50) aus dem zweiten Permanentmagneten besteht, der eine Ringform aufweist, die einen zentralen Kreis definiert, oder aus einer Vielzahl von Permanentmagneten, die entlang eines geometrischen Kreises angeordnet sind; dadurch, dass der zentrale Kreis oder der geometrische Kreis einen Durchmesser aufweist, der größer als der Außendurchmesser des ersten Permanentmagneten (12) ist und, wenn sich das flexible Element in der Ruheposition befindet, auf der Mittelachse des ersten Permanentmagneten zentriert ist; und dadurch, dass der Durchmesser des zentralen Kreises oder des geometrischen Kreises so gewählt ist, dass die Magnetkraft zwischen dem ersten Permanentmagneten und dem zweiten Permanentmagneten, bzw. der Vielzahl von Permanentmagneten bei der Bewegung des mechanischen Elements (22) aus der Ruheposition bis zur Kontaktposition eine Richtungsumkehr aufweist.

9. Uhrmachereistück nach Anspruch 2, **dadurch gekennzeichnet, dass** der Permanentmagnet (52) eine Ringform aufweist.

10. Uhrmachereistück nach Anspruch 3, **dadurch gekennzeichnet, dass** der erste Permanentmagnet (52) eine Ringform aufweist.

11. Uhrmachereistück nach Anspruch 9, **dadurch gekennzeichnet, dass** das ferromagnetische Element (74) eine Form einer vollen Rolle, insbesondere eine Scheibenform, aufweist; und dadurch, dass dieses ferromagnetische Element angeordnet ist, um auf einer Mittelachse des Permanentmagneten ausgerichtet zu sein, wenn sich das mechanische Element in seiner Ruheposition befindet.

12. Uhrmachereistück nach Anspruch 11, **dadurch gekennzeichnet, dass** das ferromagnetische Element angeordnet ist, um zumindest teilweise in einem Innenraum des ringförmigen Permanentmagneten positioniert zu sein, wenn sich das mechanische Element in der Ruheposition befindet.

13. Uhrmachereistück nach Anspruch 11 oder 12, **dadurch gekennzeichnet, dass** der Permanentmagnet (52), das ferromagnetische Element (74) und das elastische Element (20) konfiguriert und angeordnet sind, sodass die Summe der mechanischen Rückstellkraft und der magnetischen Kraft über die gesamte Distanz, die das mechanische Element zurücklegen kann, eine Richtung aufweist, die der Richtung der Bewegung dieses mechanischen Elements von der Ruheposition bis zur Kontaktposition entgegengesetzt ist, um über die gesamte Distanz eine Gesamtrückstellkraft des mechanischen Elements in die Ruheposition zu bilden.

14. Uhrmachereistück nach Anspruch 10, **dadurch gekennzeichnet, dass** der zweite Permanentmagnet (54) eine Form einer vollen Rolle, insbesondere eine Scheibenform, aufweist; und dadurch, dass der zweite Permanentmagnet angeordnet ist, um auf einer Mittelachse des ersten Permanentmagneten ausgerichtet zu sein, wenn sich das mechanische Element in der Ruheposition befindet.

15. Uhrmachereistück nach Anspruch 14, **dadurch gekennzeichnet, dass** der zweite Permanentmagnet angeordnet ist, sodass die magnetische Kraft zwischen dem ersten Permanentmagneten (52) und dem zweiten Permanentmagneten (54) bei der Bewegung des mechanischen Elements (22) aus der Ruheposition bis zur Kontaktposition eine Richtungsumkehr aufweist.

16. Uhrmachereistück nach Anspruch 15, **dadurch gekennzeichnet, dass** der erste Permanentmagnet, der zweite Permanentmagnet und das elastische Element (20) konfiguriert und angeordnet sind, sodass die Summe der mechanischen Rückstellkraft und der magnetischen Kraft über die gesamte Distanz, die das mechanische Element (22) zurücklegen kann, eine Richtung aufweist, die der Richtung der Bewegung dieses mechanischen Elements von der Ruheposition bis zur Kontaktposition entgegengesetzt ist, um über die gesamte Distanz eine Gesamtrückstellkraft des mechanischen Elements in die Ruheposition zu bilden.

## Claims

1. Timepiece (2) incorporating an actuator formed by an electromechanical device (6; 6A; 6B; 6C; 6D), which comprises an electromagnetic system (10; 10A; 10B; 10C; 10D) as well as a mechanical element (22) that is mobile in translation and associated with the electromagnetic system, and by an electric control circuit (8), the electromagnetic system being formed by a permanent magnet (12, 52) and a coil (14), one out of the two of which is carried by a flexible member (16) of the electromechanical device and the other by a support (18) of this flexible member, said mechanical element being formed by said flexible member and the actuator being arranged in such a way as to allow, in response to an electric activation signal generated by the electric control circuit and provided to the coil to engender an electromagnetic force between this coil and said permanent magnet, a movement of the mechanical element from a rest position, in which it is provided that the mechanical element remains in the absence of an activation of the electromagnetic system, to a position of contact with a determined part (24) of the timepiece, in which said flexible member is formed at least partially by an elastic element (20) that is arranged in such a way as to engender a mechanical force of return of the mechanical element in the direction of said rest position over at least a majority of the distance that the mechanical element can travel, when the electric control circuit generates said electric activation signal, between the rest position and the contact position, this contact position ending said at least a majority of said distance, the actuator further comprising a magnetic element (26; 50; 54; 74) arranged in such a way as to be able to interact with said permanent magnet (12; 52) to engender between them a magnetic force that is exerted on the mechanical element when the latter is in the rest position, this magnetic force having a direction opposite to that of said electromagnetic force over at least an initial part of said distance from the rest position and an intensity which decreases, over said at least an initial part, when the mechanical element moves away from the rest position and which is less than the intensity that said electromagnetic force has for any position of said mechanical element in said at least an initial part.

2. Timepiece according to claim 1, **characterised in that** said magnetic element (26; 74) consists of a ferromagnetic material.

3. Timepiece according to claim 1, wherein said permanent magnet is a first magnet, **characterised in that** said magnetic element (50; 54) is formed by a second permanent magnet arranged in magnetic attraction with the first magnet when said mechanical element (22) is in the rest position.

4. Timepiece according to claim 2, **characterised in that** said permanent magnet (12) has a solid, flat, round shape, in particular the shape of a disc, and **in that** said magnetic element is arranged in such a way as to be aligned on a central axis of the permanent magnet when the mechanical element is in the rest position.

5. Timepiece according to claim 3, **characterised in that** the first permanent magnet (12) has a solid, flat, round shape, in particular the shape of a disc, and **in that** said magnetic element is arranged in such a way as to be aligned on a central axis of the first permanent magnet when the mechanical element is in the rest position.

6. Timepiece according to claim 4, **characterised in that** said ferromagnetic element (26; 74) has a solid, flat, round shape, in particular the shape of a disc.

7. Timepiece according to claim 5, **characterised in that** the second permanent magnet (54) has a solid, flat, round shape, in particular the shape of a disc.

8. Timepiece according to claim 5, **characterised in that** said magnetic element (50) consists of the second permanent magnet, which has an annular shape defining a central circle, or of a plurality of permanent magnets arranged along a geometric circle; **in that** said central circle or said geometric circle has a diameter that is greater than the outer diameter of the first permanent magnet (12) and is, when the flexible member is in the rest position, centred on the central axis of the first permanent magnet; and **in that** the diameter of the central circle or of the geometric circle is selected so that said magnetic force between the first permanent magnet and the second permanent magnet, respectively the plurality of permanent magnets, has an inversion of direction during said movement of said mechanical element (22) from the rest position to the contact position.

9. Timepiece according to claim 2, **characterised in that** said permanent magnet (52) has an annular shape.

10. Timepiece according to claim 3, **characterised in that** the first permanent magnet (52) has an annular shape.

11. Timepiece according to claim 9, **characterised in that** said ferromagnetic element (74) has a solid, flat, round shape, in particular the shape of a disc, and **in that** this ferromagnetic element is arranged in such a way as to be aligned on a central axis of said permanent magnet when the mechanical element is in its rest position.

12. Timepiece according to claim 11, **characterised in that** the ferromagnetic element is arranged in such a way as to be positioned at least partially in an inner space of the annular permanent magnet when said mechanical element is in the rest position.

13. Timepiece according to claim 11 or 12, **characterised in that** the permanent magnet (52), the ferromagnetic element (74) and the elastic element (20) are configured and arranged in such a way that the sum of said mechanical return force and said magnetic force has, over all of said distance that said mechanical element can travel, a direction opposite to the direction of said movement of this mechanical element from the rest position to the contact position, so as to form over all of said distance a total force of return of the mechanical element towards the rest position.

14. Timepiece according to claim 10, **characterised in that** the second permanent magnet (54) has a solid, flat, round shape, in particular the shape of a disc, and **in that** the second permanent magnet is arranged in such a way as to be aligned on a central axis of the first permanent magnet when the mechanical element is in the rest position.

15. Timepiece according to claim 14, **characterised in that** the second permanent magnet is arranged so that said magnetic force between the first permanent magnet (52) and the second permanent magnet (54) has an inversion of direction during said movement of said mechanical element (22) from the rest position to the contact position.

16. Timepiece according to claim 15, **characterised in that** the first permanent magnet, the second permanent magnet and the elastic element (20) are configured and arranged in such a way that the sum of said mechanical return force and said magnetic force has, over all of said distance that said mechanical element (22) can travel, a direction opposite to the direction of said movement of this mechanical element from the rest position to the contact position, so as to form over all of said distance a total force of return of the mechanical element towards the rest position.
